# EUROPEAN PATENT APPLICATION

(11) **EP 4 425 585 A1**
(43) Date of publication of application: **04.09.2024**
(21) Application number: 24159906.7
(22) Date of filing: 27.02.2024
(51) Int. Cl.: H01L 33/44, H01L 33/46, H01L 33/50, H01L 33/56, H01L 33/60

(54) **WAVELENGTH-CONVERTED SEMICONDUCTOR LIGHT-EMITTING DEVICE**

(30) Priority: 28.02.2023 KR 20230026912
(71) Applicant: Samsung Electronics Co., Ltd., Suwon-si, Gyeonggi-do 16677 (KR)
(72) Inventor: JEONG, Juwon, 16677 Suwon-si, Gyeonggi-do (KR); KIM, Sanghyun, 16677 Suwon-si, Gyeonggi-do (KR); YOU, Jiho, 16677 Suwon-si, Gyeonggi-do (KR); CHOI, Sungwoo, 16677 Suwon-si, Gyeonggi-do (KR)
(74) Representative: Kuhnen & Wacker Patent- und Rechtsanwaltsbüro PartG mbB

(57) **Abstract**

A semiconductor light-emitting device (100, 100A) includes a light emitting structure (110), a wavelength conversion member (120) arranged on an upper surface (110U) of the light emitting structure, the wavelength conversion member including a first surface (120F1) in contact with the light emitting structure, a second surface (120F2) opposite to the first surface, and a sidewall (120S), wherein the first surface entirely covers the upper surface of the light emitting structure, and a portion (120_IS) of the sidewall adjacent to the first surface is slanted with respect to the first surface, and a coating layer (130) arranged on the second surface of the wavelength conversion member, the coating layer including a first material layer (132) and a second material layer (134) alternately stacked on the second surface, wherein the first material layer includes an oxide, and the second material layer includes magnesium fluoride, MgF₂, wherein the second material layer (134) is arranged at an uppermost surface (130U) of the coating layer.

## Description

### BACKGROUND

The inventive concept relates to a semiconductor light-emitting device, and more particularly, to a semiconductor light-emitting device emitting white color light.

The semiconductor light-emitting devices are widely used as light sources for lighting apparatuses or light sources for display apparatuses. In general, white color light elements include wavelength conversion members such as phosphor on blue light-emitting devices. To implement high power white color devices operating at high temperature, the development of wavelength conversion members having high mechanical, thermal, and chemical stability is required.

### SUMMARY

The inventive concept provides a semiconductor light-emitting device having improved orientation angle characteristics and light-flux characteristics. Embodiments of the invention are set out in the appended claims.

According to an aspect of the inventive concept, there is provided a semiconductor light-emitting device including a light emitting structure, a wavelength conversion member arranged on an upper surface of the light emitting structure, the wavelength conversion member including a first surface in contact with the light emitting structure, a second surface opposite to the first surface, and a sidewall, wherein the first surface entirely covers the upper surface of the light emitting structure, and a portion of the sidewall adjacent to the first surface is slanted with respect to the first surface, and a coating layer arranged on the second surface of the wavelength conversion member, the coating layer including a first material layer and a second material layer alternately stacked on the second surface, wherein the first material layer includes an oxide, and the second material layer includes magnesium fluoride (MgF₂), wherein the second material layer is arranged at an uppermost surface of the coating layer.

According to another aspect of the inventive concept, there is provided a semiconductor light-emitting device including a light emitting structure, a wavelength conversion member arranged on an upper surface of the light emitting structure, the wavelength conversion member including a first surface in contact with the light emitting structure, a second surface opposite to the first surface, and a sidewall, wherein the first surface entirely covers the upper surface of the light emitting structure, and the sidewall includes a slanted surface slanted with respect to the first surface at a location adjacent to the first surface, and a coating layer arranged on the second surface of the wavelength conversion member, the coating layer including a first material layer and a second material layer alternately stacked on the second surface, wherein the first material layer includes an oxide, the second material layer includes magnesium fluoride (MgF₂), and the second material layer is arranged at the uppermost surface of the coating layer, wherein the first material layer has a first refractive index, and the second material layer has a second refractive index, wherein the second refractive index is less than the first refractive index.

According to another aspect of the inventive concept, there is provided a semiconductor light-emitting device including a light emitting structure including a first conductivity type semiconductor layer, an active layer, and a second conductivity type semiconductor layer, wherein the light emitting structure is configured to emit light having a wavelength range of about 400 nm to about 700 nm, a wavelength conversion member arranged on an upper surface of the light emitting structure, the wavelength conversion member including a first surface in contact with the light emitting structure, a second surface opposite to the first surface, and a sidewall, wherein a first portion of the sidewall adjacent to the first surface is slanted with respect to the first surface and a second portion of the sidewall adjacent to the second surface extends vertically with respect to the second surface, a coating layer arranged on the second surface of the wavelength conversion member, the coating layer including a first material layer and a second material layer alternately stacked on the second surface, wherein the first material layer includes oxide, the second material layer includes magnesium fluoride (MgF₂), the first material layer and the second material layer function as a distributed Bragg reflector (DBR), and the second material layer is arranged at the uppermost surface of the coating layer, and a reflection layer surrounding a sidewall of the light emitting structure and the sidewall of the wavelength conversion member, wherein the wavelength conversion member includes a base material layer, phosphors dispersed in the base material layer, and inorganic oxide particles dispersed in the base material layer.

### BRIEF DESCRIPTION of THE DRAWINGS

Embodiments will be more clearly understood from the following detailed description taken in conjunction with the accompanying drawings in which:
FIG. 1 is a cross-sectional view of a semiconductor light-emitting device according to an example embodiment;
FIG. 2 is an enlarged view of region A in FIG. 1;
FIG. 3 is a cross-sectional view of a semiconductor light-emitting device according to an example embodiment;
FIG. 4 is an enlarged view of region A1 in FIG. 3;
FIG. 5 is a cross-sectional view of a semiconductor light-emitting device according to an example embodiment;
FIG. 6 is an enlarged view of region A1 in FIG. 5;
FIG. 7 is a graph of transmittance of a semiconductor light-emitting device according to an example embodiment;
FIG. 8 is a graph of color over angle characteristics per viewing angle of a semiconductor light-emitting device according to an example embodiment;
FIG. 9A is a graph of color coordinates characteristics of a semiconductor light-emitting device according to an example embodiment, and FIG. 9B is a graph of light-flux characteristics of a semiconductor light-emitting device according to an example embodiment;
FIG. 10A is a graph of color coordinates characteristics of a semiconductor light-emitting device according to an example embodiment, and FIG. 10B is a graph of light-flux characteristics of a semiconductor light-emitting device according to an example embodiment;
FIG. 11 is a perspective view schematically illustrating a lighting apparatus including a semiconductor light-emitting device according to an example embodiment;
FIG. 12 is a perspective view schematically illustrating a flat lighting apparatus including a semiconductor light-emitting device according to an example embodiment;
FIG. 13 is an exploded perspective view schematically illustrating a lighting apparatus including a semiconductor light-emitting device according to an example embodiment;
FIG. 14 is a perspective view schematically illustrating a lighting apparatus of a bar type including a semiconductor light-emitting device according to an example embodiment;
FIG. 15 is an exploded perspective view schematically illustrating a lighting apparatus including a semiconductor light-emitting device according to an example embodiment;
FIG. 16 is a schematic diagram illustrating an indoor lighting control network system including a semiconductor light-emitting device according to an example embodiment; and
FIG. 17 is a schematic diagram illustrating a network system including a semiconductor light-emitting device according to an example embodiment.

### DETAILED DESCRIPTION of THE EMBODIMENTS

Hereinafter, desirable embodiments of the inventive concept are described in detail in conjunction with the accompanying drawings. Throughout the specification, the same reference numerals are used to indicate the same components.

It will be understood that, although the terms "first," "second," "third," etc. may be used herein to describe various elements, components, regions, layers and/or sections, these elements, components, regions, layers and/or sections should not be limited by these terms. Unless the context indicates otherwise, these terms are only used to distinguish one element, component, region, layer or section from another element, component, region, layer or section, for example as a naming convention. Thus, a first element, component, region, layer or section discussed below in one section of the specification could be termed a second element, component, region, layer or section in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

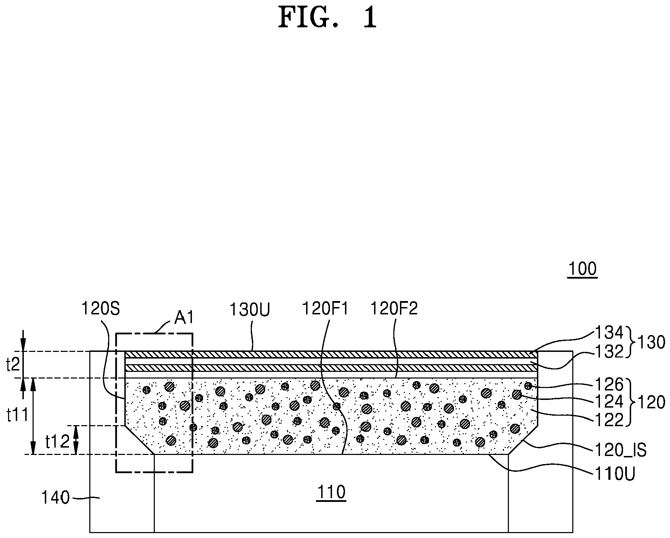

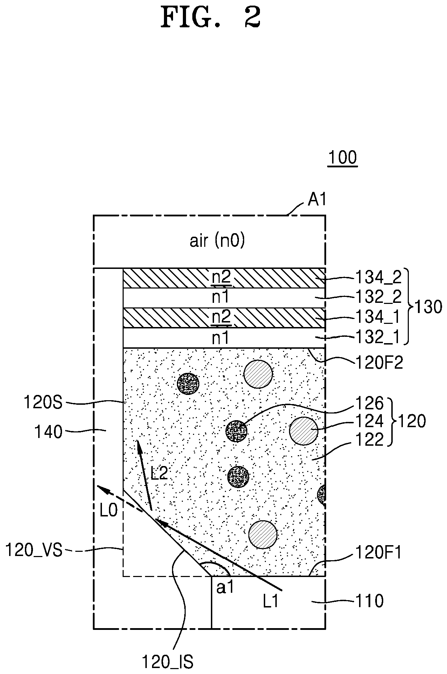

FIG. 1 is a cross-sectional view of a semiconductor light-emitting device 100 according to an example embodiment. FIG. 2 is an enlarged view of region A1 in FIG. 1.

Referring to FIGS. 1 and 2, the semiconductor light-emitting device 100 may include a light emitting structure 110, a wavelength conversion member 120, a coating layer 130, and a reflection layer 140.

The light emitting structure 110 may be configured to emit light toward the wavelength conversion member 120, and the light having passed through the wavelength conversion member 120 may be directed upward toward an upper side of the semiconductor light-emitting device 100. The light emitting structure 110 may be configured to emit light of a first wavelength, and for example, the light emitted by the light emitting structure 110 may have a wavelength range of about 400 nm to about 700 nm. In some embodiments, the light emitting structure 110 may be configured to emit light of the first wavelength, and convert the light of the first wavelength into light of a second wavelength longer than the first wavelength when the light of the first wavelength passes through the wavelength conversion member 120. In some embodiments, the first wavelength may range from about 400 nm to about 500 nm and the second wavelength may range from about 450 nm to about 700 nm.

In some embodiments, the light emitting structure 110 may be configured to emit light in a blue light wavelength range, and the light having passed through the wavelength conversion member 120 and directed toward the top of the semiconductor light-emitting device 100 may include white color light. In some embodiments, the light directed toward the top of the semiconductor light-emitting device 100 may include white color light having various color coordinates. In some embodiments, the light directed toward the top of the semiconductor light-emitting device 100 may have a color coordinate of (x, y) and may include white color light, in which x and y are each in a range of about 0.28 to about 0.38. In some embodiments, the light directed toward the top of the semiconductor light-emitting device 100 may have a color coordinate of (x, y) and may include white color light, in which x and y are each in a range of about 0.31 to about 0.34.

In some embodiments, the light directed toward the top of the semiconductor light-emitting device 100 may include reddish white color light, yellowish white color light, or bluish white color light.

The light emitting structure 110 may include a semiconductor layer of a first conductivity-type semiconductor layer, an active layer, and a second conductivity-type semiconductor layer. The first conductivity-type semiconductor layer and the second conductivity-type semiconductor layer may be stacked with an active layer therebetween. Although not illustrated in FIG. 1, the light emitting structure 110 may be mounted on a support carrier, a printed circuit board, a lead frame, or a package substrate.

In some embodiments, the first conductivity-type semiconductor layer may include a nitride semiconductor having a composition of n-type InₓAl_{y}Ga_{(1-x-y)}N (0≤x<1, 0≤y<1, and 0≤x+y<1), and the n-type impurity may include, for example, silicon (Si). For example, the first conductivity-type semiconductor layer may include GaN including n-type impurities.

In some embodiments, the first conductivity-type semiconductor layer may include a first conductivity-type semiconductor contact layer and a current diffusion layer. The impurity concentration of the first conductivity-type semiconductor contact layer may range from about 2×10¹⁸ cm⁻³ to about 9×10¹⁹ cm⁻³. The thickness of the first conductivity-type semiconductor contact layer may be about 1 µm to about 5 µm. The current diffusion layer may have a structure in which a plurality of InₓAl_{y}Ga_{(1-x-y)}N (0≤x, y≤1, and 0≤x+y≤1) layers having different compositions or different impurity contents are alternately stacked. For example, the current diffusion layer may have an n-type super lattice structure in which an n-type GaN layer and/or an AlₓIn_{y}Ga_{z}N layer (0≤x,y,z≤1, and x+y+z≠0), each having a thickness of about 1 nm to about 500 nm, are alternately stacked. The impurity concentration of the current diffusion layer may be about 2 × 10¹⁸ cm⁻³ to about 9×10¹⁹ cm⁻³. As used herein, the term "thickness" may refer to the thickness or height measured in a direction perpendicular to a top surface of the light emitting structure 110.

In some embodiments, the active layer may be arranged between the first conductivity-type semiconductor layer and the second conductivity-type semiconductor layer. The active layer may be configured to emit light having certain energy by recombining electrons and holes when the semiconductor light-emitting device 100 is driven. The active layer may have a multiple quantum well structure in which a quantum well layer and a quantum barrier layer are alternately stacked. For example, the quantum well layer and the quantum barrier layer may include InₓAl_{y}Ga_{(1-x-y)}N (0≤x, y≤1, and 0≤x+y≤1) with different compositions. For example, the quantum well layer may include InₓGa₁₋ₓN (0≤x≤1) and the quantum barrier layer may include GaN or AlGaN. The thickness of each of the quantum well layer and the quantum barrier layer may range from about 1 nm to about 50 nm. The active layer is not limited to the multiple quantum well structure, and may include a single quantum well structure.

In some embodiments, the second conductivity-type semiconductor layer may include a nitride semiconductor layer having a composition of p-type InₓAl_{y}Ga_{(1-x-y)}N (0≤x<1, 0≤y<1, and 0≤x+y<1), and for example, the p-type impurities may include magnesium (Mg).

In some embodiments, the second conductivity-type semiconductor layer may include an electron blocking layer (not illustrated), a low-concentration p-type GaN layer (not illustrated), and a high-concentration p-type GaN layer (not illustrated). For example, the electron blocking layer may have a structure in which a plurality of InₓAl_{y}Ga_{(1-x-y)}N (0≤x, y≤1, and 0≤x+y≤1) layers, each having different compositions and a thickness of about 5 nm to about 100 nm, are alternately stacked, or may include a single layer including Al_{y}Ga_{(1-y)}N (0<y≤1). An energy band gap of the electron blocking layer may decrease away from the active layer. For example, the aluminum (Al) composition of the electron blocking layer may decrease away from the active layer.

The light emitting structure 110 may be arranged so that the second conductivity-type semiconductor layer forms a light emitting surface, and, for example, may be configured to emit light having a wavelength range of about 400 nm to about 700 nm by using the second conductivity-type semiconductor layer. However, the materials and structures of the first conductivity-type semiconductor layer, the active layer, and the second conductivity-type semiconductor layer, which constitute the light emitting structure 110 described above, are examples and are not limited thereto.

The wavelength conversion member 120 may be arranged on the light emitting structure 110. The wavelength conversion member 120 may include a first surface 120F1 and a second surface 120F2 opposite to the first surface 120F1, and the first surface 120F1 may be arranged to contact an upper surface 110U of the light emitting structure 110.

In some embodiments, the wavelength conversion member 120 may include a material capable of converting at least a portion of light emitted by the light emitting structure 110 into light having a longer wavelength range. For example, the wavelength conversion member 120 may convert at least a portion of light in a blue color wavelength range emitted by the upper surface 110U of the light emitting structure 110 into light in a yellow color wavelength range and emit the light in the yellow color wavelength range onto the second surface 120F2 of the wavelength conversion member 120, and may be configured to emit white color light onto an upper side of the semiconductor light-emitting device 100 by using a combination of the light in the blue color wavelength range and the light in the yellow color wavelength range.

In other embodiments, the wavelength conversion member 120 may convert at least a portion of light in the blue color wavelength range emitted by the upper surface 110U of the light emitting structure 110 into light in the yellow color wavelength range and light in a red color wavelength range and emit the light in the yellow color wavelength range and the light in the red color wavelength range onto the second surface 120F2 of the wavelength conversion member 120, and may be configured to emit white color light onto an upper side of the semiconductor light-emitting device 100 by using a combination of the light in the blue color wavelength range, the light in the yellow color wavelength range, and the light in the red color wavelength range.

In other embodiments, the wavelength conversion member 120 may convert at least a portion of light in the blue color wavelength range emitted by the upper surface 110U of the light emitting structure 110 into light in a green color wavelength range and light in the red color wavelength range and emit the light in the green color wavelength range and the light in the red color wavelength range onto the second surface 120F2 of the wavelength conversion member 120, and may be configured to emit white color light upward from the semiconductor light-emitting device 100 by using a combination of the light in the blue color wavelength range, the light in the green color wavelength range, and the light in the red color wavelength range.

In some embodiments, the wavelength conversion member 120 may include a base material layer 122, phosphors 124 dispersed in the base material layer 122, and inorganic oxide particles 126 dispersed in the base material layer 122.

In some embodiments, the base material layer 122 may include ceramic, glass, or silicone resin. In some embodiments, the base material layer 122 may be provided in a sintered or solidified form, by mixing glass frit or glass flux with the phosphors 124 in a resin or an organic solution. In some embodiments, the base material layer 122 may be provided in the form of a flat panel entirely covering the upper surface 110U of the light emitting structure 110 and may be provided, for example, in the form of a plate or thick film.

The phosphors 124 may include a material that absorbs light in a wavelength range of about 250 nm to about 800 nm, converts the light into light in a range of about 300 nm to about 1000 nm, and emits the converted light. The phosphors 124 may desirably include at least any one of nitride/oxynitride-based phosphor doped with lanthanoid-based elements, such as europium (Eu) and cerium (Ce), alkaline earth halogen apatite phosphor doped with lanthanoid elements such as Eu and transition metal-based elements such as manganese (Mn), alkaline earth metal boric acid halogen phosphor, alkaline earth metal aluminate phosphor, alkaline earth silicate phosphor, alkaline earth emulsion-type phosphor, alkaline earth thiogalate phosphor, alkaline earth silicon nitride phosphor, germanic acid salt phosphor, rare earth aluminate phosphor doped with lanthanoid elements such as Ce, and organic and organic complex phosphor doped with lanthanoid elements, such as rare earth silicate and Eu. The phosphors below may be used as examples but are not limited thereto.

The nitride-based phosphor doped with lanthanoid-based elements, such as Eu and Ce, may include M₂Si₅N₈ : Eu (M is at least one of strontium (Sr), calcium (Ca), barium (Ba), magnesium (Mg), and zinc (Zn)), etc. In addition to M₂Si₅N₈ : Eu, the nitride-based phosphor doped with lanthanoid-based elements may include MSi₇N₁₀ : Eu, M_{1.8}Si₅O_{0.2}N₈ : Eu, M_{0.9}Si₇O_{0.1}N₁₀ : Eu (M is at least one selected from Sr, Ca, Ba, Mg, and Zn), etc. The oxynitride-based phosphor doped with lanthanoid elements, such as Eu and Ce, may include MSi₂O₂N₂ : Eu (M is at least one selected from Sr, Ca, Ba, Mg, and Zn).

The alkaline earth halogen apatite phosphor doped with lanthanoid elements such as Eu and transition metal-based elements such as Mn may include M₅(PO₄)₃ X : R (M is at least one of Sr, Ca, Ba, Mg, and Zn, X is at least one of fluorine (F), chlorine (Cl), bromine (Br), and iodine (I), and R is at least one of Eu and Mn), etc. The alkaline earth metal boric acid halogen phosphor may include M₂B₅O₉X : R (M is at least one of Sr, Ca, Ba, Mg, and Zn, X is at least one of F, Cl, Br, and I, and R is at least one of Eu and Mn), etc. The alkaline earth metal aluminate phosphor may include SrAl₂O₄ : R, Sr₄Al₁₄O₂₅ : R, CaAl₂O₄ : R, BaMg₂Al₁₆O₂₇ : R, BaMg₂Al₁₆O₁₂ : R, and BaMgAl₁₀O₁₇ : R (R is any one of Eu and Mn). The alkaline earth emulsion-type phosphor may include La₂O₂S : Eu, Y₂O₂S : Eu, Gd₂O₂S : Eu, etc. The rare earth aluminate phosphor doped with lanthanoid elements such as Ce may include yttrium aluminum garnet (YAG)-based phosphor or the like having composition formulas, such as Y₃Al₅O₁₂ : Ce, (Y_{0.8}Gd_{0.2})₃Al₅O₁₂ : Ce, Y₃(Al_{0.8}Ga_{0.2})₅ O₁₂ : Ce, and (Y, Gd)₃ (Al, Ga)s O₁₂. In addition, the rare earth aluminate phosphor doped with lanthanoid elements such as Ce may include Tb₃Al₅O₁₂ : Ce, Lu₃Al₅O₁₂ : Ce, or the like, where some or all of the Ys in the composition formulas thereof are replaced by terbium (Tb), lutetium (Lu), etc. The alkaline earth silicate phosphor may include silicate, and a representative example thereof may include (SrBa)₂SiO₄:Eu, etc. Other phosphors may include ZnS : Eu, Zn₂GeO₄ : Mn, MGa₂S₄ : Eu (M is at least one of Sr, Ca, Ba, Mg, and Zn, and X is at least one of F, Cl, Br, and I), etc.

The phosphors described above may also include at least one element of Tb, copper (Cu), silver (Ag), gold (Au), chrome (Cr), neodymium (Nd), dysprosium (Dy), cobalt (Co), nickel (Ni), and titanium (Ti), by replacing Eu with the at least one element or by adding the at least one element to Eu. In addition, phosphors which have the same performance and effect as the phosphors described above, may also be used as phosphors except for the phosphors described above.

The inorganic oxide particles 126 may include inorganic particles, such as silicon oxide, aluminum oxide, and zirconium oxide, and may have a particle size of, for example, about 1 to about 100 micrometers. In some embodiments, the inorganic oxide particles 126 may have a particle size of about 4 micrometers to about 20 micrometers. The inorganic oxide particles 126 may be uniformly dispersed in the base material layer 122 and may improve the light extraction efficiency of the second surface 120F2 of the wavelength conversion member 120.

In some embodiments, the phosphors 124 may be included in the base material layer 122 with an amount of about 10 to about 35 wt% and the inorganic oxide particles 126 may be included in the base material layer 122 with an amount of about 10 to about 30 wt%. The phosphors 124 and the inorganic oxide particles 126 having the aforementioned amounts, and the glass frit having the residual amount may be mixed in a resin or solution to be sintered at a temperature of, for example, about 400 °C to about 800 °C, and after subsequent surface treatment or the like, the wavelength conversion member 120 of a plate or thick film form may be formed. For example, a first thickness 111 of the wavelength conversion member 120 may range from about 50 micrometers to about 300 micrometers.

As illustrated in FIG. 1, the wavelength conversion member 120 may include a sidewall 120S, an upper side of the sidewall 120S may extend substantially vertically with respect to the first surface 120F1 of the wavelength conversion member 120, and a lower side of the sidewall 120S may be inclined at a first inclination angle a1 with respect to the first surface 120F1 of the wavelength conversion member 120. For example, the upper side of the sidewall 120S may be perpendicular with respect to the first surface 120F1 of the wavelength conversion member 120. The lower side of the sidewall 120S may be referred to as a portion of the sidewall 120S arranged adjacent to the first surface 120F1 of the wavelength conversion member 120, and the upper side of the sidewall 120S may be referred to as a portion of the sidewall 120S arranged adjacent to the second surface 120F2 of the wavelength conversion member 120. In this case, the lower side of the sidewall 120S may be referred to as an inclined surface 120_IS. The first inclination angle a1 with respect to the first surface 120F1 of the inclined surface 120_IS may have an obtuse angle and may be, for example, in a range of about 100 to about 150 degrees.

As the inclined surface 120_IS of the wavelength conversion member 120 is inclined at the first inclination angle a1 with respect to the first surface 120F1, the area of the second surface 120F2 of the wavelength conversion member 120 may be greater than the area of the first surface 120F1 of the wavelength conversion member 120. Accordingly, the area of the second surface 120F2 of the wavelength conversion member 120 may be greater than the area of the upper surface 110U of the light emitting structure 110. In some embodiments, the inclined surface 120_IS of the wavelength conversion member 120 may be formed by a chamfering process or a bevel cutting process. In some embodiments, the portion of the wavelength conversion member 120 corresponding to the inclined surface 120_IS may have a second thickness t12 in a vertical direction, and the second thickness t12 may correspond to about 10 to about 50 % of the first thickness t11 of the wavelength conversion member 120. For example, the second thickness 112 may correspond to the thickness from a level of the first surface 120F1 to a level at which the vertical portion of the side surface 120S intersects the inclined surface 120_IS. For example, the width of the inclined surface 120_IS in the horizontal direction may correspond to about 5 micrometers to about 50 micrometers. The width of the inclined surface 120_IS in the horizontal direction may correspond to the horizontal distance from a side surface of the light emitting structure 110 to a side surface of the vertical portion of the side surface 120S.

In FIG. 2, illustrated as a dash-dotted line for comparison is a vertical lower sidewall 120_VS of the wavelength conversion member 120 in the case when the inclined surface 120_IS is not formed. As illustrated in the schematic diagram in FIG. 2, when the inclined surface 120_IS is not formed, incident light L1 emitted from the upper surface 110U of the light emitting structure 110 and passing through the wavelength conversion member 120 may be emitted to the outside of the wavelength conversion member 120 via the vertical lower sidewall 120_VS. An optical path in this case may be referred to as a comparative optical path L0 and may be represented by a dashed arrow. According to some embodiments, when the wavelength conversion member 120 includes the inclined surface 120_IS, the incident light L1 may be reflected by the inclined surface 120_IS, re-directed in a direction toward the second surface 120F2 of the wavelength conversion member 120, and emitted upward via a second surface 120F. In this manner, the inclined surface 120_IS may improve light extraction efficiency or light-flux of the semiconductor light-emitting device 100.

The coating layer 130 may be arranged on a second surface 110F2 of the wavelength conversion member 120. The coating layer 130 may have a distributed Bragg reflector (DBR) structure and may include, for example, a first material layer 132 and a second material layer 134, which are alternately arranged on the second surface 110F2 of the wavelength conversion member 120. The second material layer 134 may be arranged on an outermost surface 130U of the coating layer 130. The second material layer 134 arranged on the outermost surface 130U of the coating layer 130 may be formed as a continuous material layer extending in a direction in parallel with the second surface 120F2 of the wavelength conversion member 120. For example, the upper surface of the second material layer 134 arranged on the outermost surface 130U of the coating layer 130 may have a flat profile extending in parallel with the second surface 120F2 of the wavelength conversion member 120.

In the embodiments illustrated in FIGS. 1 and 2, the first material layer 132 may be include n layers, the second material layer 134 may include n layers (in this case, n is a natural number equal to or greater than 1), and the total number of first material layers 132 and second material layers 134 may be an even number. For example, the total number of first material layers 132 and second material layers 134 may be 2, 4, 6, 8, or 10. FIG. 2 illustrates a case where the total number of first material layers 132 and second material layers 134 is 4, and for example, a lower first material layer 132_1, a lower second material layer 134_1, an upper first material layer 132_2, and an upper second material layer 134_2 may be sequentially arranged on the second surface 120F2 of the wavelength conversion member 120.

The second material layer 134 on the uppermost portion (for example, the upper second material layer 134_2) may be arranged at the outermost surface 130U of the coating layer 130, the first material layer 132 on the lowermost portion (for example, the lower first material layer 132_1) may be arranged directly on the second surface 120F2 of the wavelength conversion member 120, and the first material layer 132 on the lowermost portion (for example, the lower first material layer 132_1) may contact the entire upper surface of the second surface 120F2 of the wavelength conversion member 120. An upper surface of the second material layer 134 on the uppermost portion (for example, the upper second material layer 134_2) may form the outermost surface 130U of the coating layer 130.

In FIG. 2, all of the lower first material layer 132_1, the lower second material layer 134_1, the upper first material layer 132_2, and the upper second material layer 134_2 are illustrated to have the same thickness, and in other embodiments, the thicknesses of the lower first material layer 132_1, the lower second material layer 134_1, the upper first material layer 132_2, and the upper second material layer 134_2 may also be formed different from each other. In still further embodiments, the thicknesses of some of the lower first material layer 132_1, the lower second material layer 134_1, the upper first material layer 132_2, and the upper second material layer 134_2 may be formed the same as each other, while the thicknesses of others of the lower first material layer 132_1, the lower second material layer 134_1, the upper first material layer 132_2, and the upper second material layer 134_2 may also be formed different from each other. In some embodiments, a thickness t2 of the coating layer 130 may range from about 50 nm to about 500 nm.

In embodiments, the first material layer 132 may be formed of and/or include an oxide and the second material layer 134 may be formed of and/or include magnesium fluoride (MgF₂). In some embodiments, the first material layer 132 may be formed of and/or include at least one of aluminum oxide, titanium oxide, hafnium oxide, tantalum oxide, silicon oxide, zirconium oxide, tungsten oxide, magnesium oxide, silicon nitride, cerium oxide, and tin oxide. In example embodiments, the first material layer 132 may be formed predominantly or solely of at least one of aluminum oxide, titanium oxide, hafnium oxide, tantalum oxide, silicon oxide, zirconium oxide, tungsten oxide, magnesium oxide, silicon nitride, cerium oxide, and tin oxide. In example embodiments, the second material layer 134 may be formed predominantly or solely of magnesium fluoride (MgF₂).

In some embodiments, the first material layer 132 and the second material layer 134 may be formed by using a physical vapor deposition (PVD) process such as an electron beam evaporation method, or chemical vapor deposition (CVD), such as a low-pressure chemical vapor deposition (LPCVD) process, a plasma-enhanced CVD (PECVD) process, and a metal organic CVD (MOCVD) process.

In some embodiments, the first material layer 132 and the second material layer 134 may have different refractive indices. In some embodiments, the first material layer 132 may have a first refractive index n1 and the second material layer 134 may have a second refractive index n2, wherein the second refractive index n2 is less than the first refractive index n1. For example, the first material layer 132 may have a first refractive index n1 in the range of about 1.5 to about 3.0 and the second material layer 134 may have a second refractive index n2 in the range of about 1.3 to about 1.45. As the second material layer 134 is arranged on the uppermost surface 130U of the coating layer 130, the difference between the second refractive index n2 of the second material layer 134 and the refractive index n0 of air may be relatively small, and accordingly, the light extraction efficiency at the interface of the coating layer 130 may be improved.

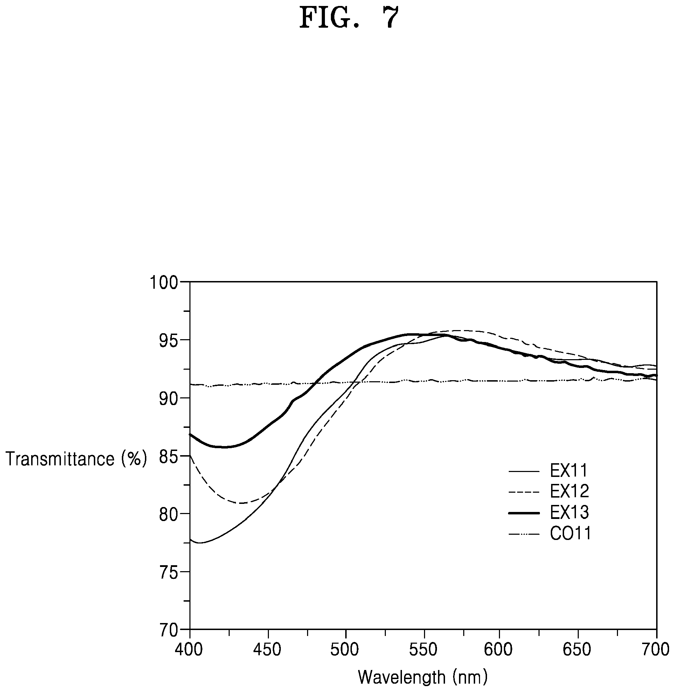

The coating layer 130 may be arranged to cover the entire upper surface of the wavelength conversion member 120, and accordingly, the color coordinates deviation according to the angle of light emitted to the upper surface of the semiconductor light-emitting device 100 may be reduced. A color coordinates that is relatively uniform over the entire angle range of the semiconductor light-emitting device 100 may be obtained. These uniform color coordinates characteristics are described below with reference to FIGS. 7 through 10B.

The reflection layer 140 may be arranged to surround the sidewall of the light emitting structure 110 and the sidewall 120S of the wavelength conversion member 120 on a support substrate (not illustrated). The reflection layer 140 may contact the sidewall of the light emitting structure 110 and the sidewall 120S of the wavelength conversion member 120 The reflection layer 140 may be formed of and/or include a resin material including highly reflective particles. In some embodiments, the highly reflective particles may include metal particles such as aluminum and silver. In some embodiments, the highly reflective particles may include at least one of ceramic particles, such as TiO₂, Al₂O₃, Nb₂O₅, and ZnO. The resin material constituting the reflection layer 140 may be formed of and/or include silicon resin, epoxy resin, or a combination thereof. The reflection layer 140 may reflect light emitted by the sidewall of the light emitting structure 110 in a direction toward the upper surface of the semiconductor light-emitting device 100, or may reflect light emitted by the sidewall 120S of the wavelength conversion member 120 in a direction toward the upper surface of the semiconductor light-emitting device 100.

In general, to form a white color light source, a light-emitting device emitting white color light may be implemented by covering an organic material-based phosphor material layer on a light emitting structure emitting light with a blue color wavelength range. Because the organic material-based phosphor material layer has issues such as color discoloration or weak mechanical strength when used at high temperatures for a long time, an inorganic or ceramic-based fluorescent plate using glass frit has been proposed. However, the inorganic-based fluorescent plate may have relatively large deviation in the color coordinates according to the orientation angle.

However, according to some embodiments, as the coating layer 130 having a DBR structure is formed on the inorganic material-based wavelength conversion member 120, the deviation of the color coordinates according to the orientation angle may be significantly reduced, and accordingly, white color light representing relatively uniform color coordinates may be obtained regardless of the orientation angle. In addition, even when the transmittance of light in some wavelength ranges decreases or the speed of light decreases due to the formation of the coating layer 130, the speed of light may be improved by using an inclined sidewall of the wavelength conversion member 120 after a bevel cutting process. Accordingly, the semiconductor light-emitting device 100 may have improved light-flux characteristics.

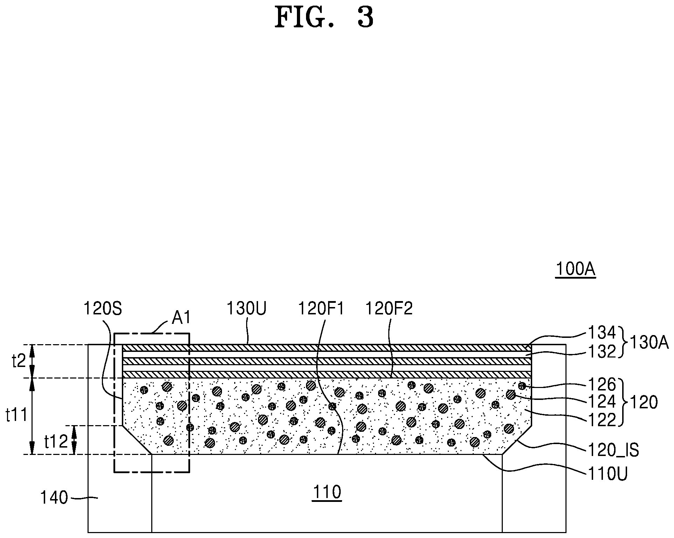

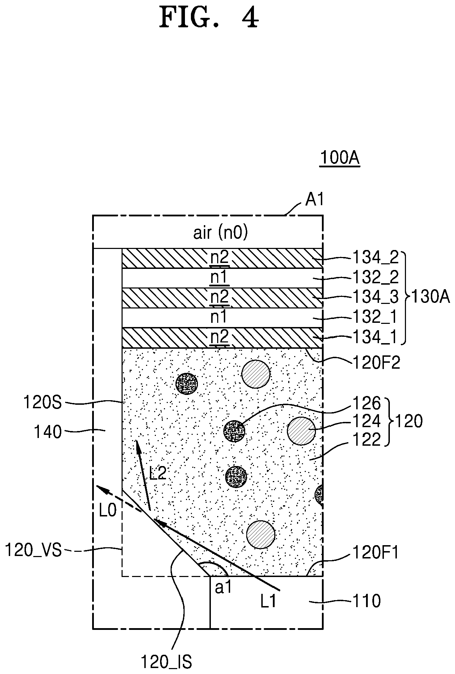

FIG. 3 is a cross-sectional view of a semiconductor light-emitting device 100A according to an example embodiment. FIG. 4 is an enlarged view of region A1 in FIG. 3. In FIGS. 3 and 4, the same reference numerals as those in FIGS. 1 and 2 denote the same components.

Referring to FIGS. 3 and 4, a coating layer 130A may include the first material layer 132 and the second material layer 134 alternately arranged on the second surface 120F2 of the wavelength conversion member 120.

In the embodiments illustrated in FIGS. 3 and 4, the first material layer 132 may be include n layers, the second material layer 134 may include n+1 layers (in this case, n is a natural number equal to or greater than 1), and the total number of first material layers 132 and second material layers 134 may be an odd number. For example, the total number of first material layers 132 and second material layers 134 may be 3, 5, 7, 9, or 11. FIG. 4 illustrates a case where the total number of first material layers 132 and second material layers 134 is 5, and for example, the lower second material layer 134_1, the lower first material layer 132_1, an intermediate second material layer 134_3, the upper first material layer 132_2, and the upper second material layer 134_2 may be sequentially arranged on the second surface 120F2 of the wavelength conversion member 120.

The second material layer 134 uppermost second at the uppermost portion (for example, the upper second material layer 134_2) may be arranged at the outermost surface 130U of the coating layer 130, the second material layer 134 at the lowermost portion (for example, the lower second material layer 134_1) may be arranged directly on the second surface 120F2 of the wavelength conversion member 120, and the second material layer 134 at the lowermost portion (for example, the lower second material layer 134_1) may contact the entire upper surface of the second surface 120F2 of the wavelength conversion member 120.

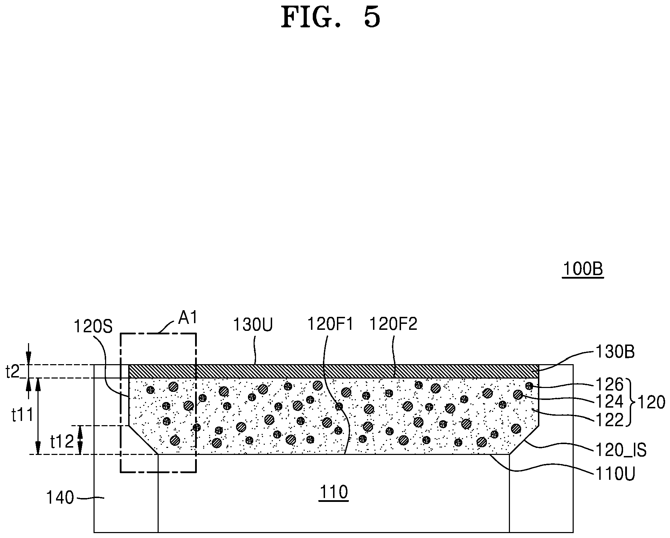

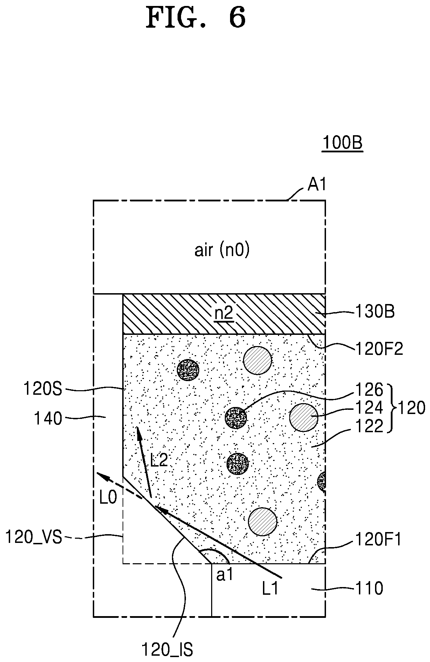

FIG. 5 is a cross-sectional view of a semiconductor light-emitting device 100B according to an example embodiment. FIG. 6 is an enlarged view of region A1 in FIG. 5. In FIGS. 5 and 6, the same reference numerals as those in FIGS. 1 through 4 denote the same components.

Referring to FIGS. 5 and 6, a coating layer 130B may be provided as a single layer and may be formed of and/or include magnesium fluoride (MgF₂). In example embodiments, the coating layer 130B may be formed predominantly or solely of magnesium fluoride (MgF₂). The thickness t2 of the coating layer 130B may be about 50 nm to about 300 nm. The coating layer 130B may contact the entire upper surface of the second surface 120F2 of the wavelength conversion member 120.

In some embodiments, the second refractive index n2 of the coating layer 130B may be in a range of about 1.3 to about 1.45. The second refractive index n2 of the coating layer 130B may be less than that of the wavelength conversion member 120, and accordingly, the difference between the second refractive index n2 and the refractive index n0 of air may be relatively small and the light extraction efficiency at the interface of the coating layer 130B may be improved.

FIG. 7 is a graph of transmittance of a semiconductor light-emitting device according to an embodiment.

Referring to FIG. 7, the transmittance of light having a wavelength range of about 400 nm to about 700 nm with respect to devices arranged according to an embodiment in the coating layer 130 (refer to FIG. 4) on the wavelength conversion member 120 (FIG. 3) is measured by using an ultraviolet (UV) - visible (Vis) spectrophotometer.

A first embodiment EX11 may represent a device in which the coating layer 130 includes a total of five material layers: two first material layers 132 including aluminum oxide; and three second material layers 134 including silicon oxide, and silicon oxide is arranged at the uppermost surface of the coating layer 130. A second embodiment EX12 may represent a device, in which the structure of the coating layer 130 is similar to that of the first embodiment EX11, but a thickness of each of the first material layer 132 and the second material layer 134 is different from the thickness of the first embodiment EX11. A third embodiment EX13 may represent a device in which the coating layer 130 includes a total of five material layers: two first material layers 132 including aluminum oxide; and three second material layers 134 including MgF₂, and MgF₂ is arranged on the uppermost surface of the coating layer 130.

A comparison example CO11 may represent transmittance of about 91 % to about 93 % in the entire range of visible light (for example, about 400 nm to about 700 nm). In all the first through third embodiments EX11 through EX13, light transmittance may be relatively low in the blue color wavelength range (for example, about 400 nm to about 500 nm) and light transmittance in the yellow color wavelength range to the red color wavelength range (for example, about 500 nm to about 700 nm) may be relatively high. The third embodiment EX13 shows higher light transmittance than the first embodiment EX11 and the second embodiment EX12 in the blue color wavelength range (for example, about 400 nm to about 500 nm). In the first and second embodiments EX11 and EX12 including silicon oxide, the transmittance reduction in the blue color wavelength range (for example, about 15 % and about 12 % reduction from the comparison example CO11) may be relatively large, but in the third embodiment EX13 including MgF₂, the transmittance reduction in the blue color wavelength range (for example, about 7 % reduction from the comparison example CO11) may be relatively small.

Accordingly, when a coating layer 130 having a DBR structure is formed, transmittance in a particular wavelength, for example, the blue color wavelength range, may be somewhat reduced, but it is identified that relatively small transmittance reduction in the blue color wavelength range is obtained due to the coating layer 130 including MgF₂.

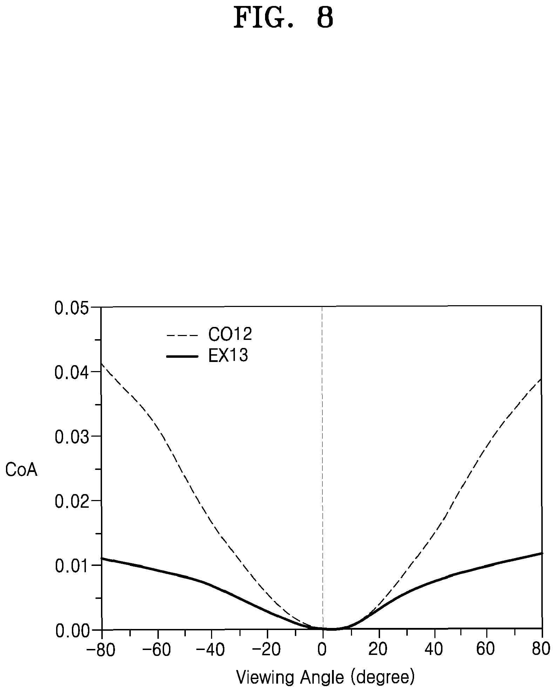

FIG. 8 is a graph of color over angle characteristics per viewing angle of a semiconductor light-emitting device, according to an embodiment.

Referring to FIG. 8, the color over angle (CoA) characteristics has been measured for the third embodiment EX13 described with reference to FIG. 7 and a comparison example CO12. In this case, the comparison example CO12 may represent a device including a single coating layer 130 including silicon oxide. The color coordinates of light emitted from the upper surface of a semiconductor light-emitting device are measured from a direction perpendicular to the upper surface of the semiconductor light-emitting device (about 0 degrees) to an inclination angle of about 80 degrees, and particularly, color coordinate values normalized by light emitted at an angle of about 0 degrees as the reference light (for example, a value obtained by dividing the color coordinate of light emitted at a certain angle by the color coordinate of the reference light) are plotted with the light emitted at 0 degrees as the "CoA".

For example, in the comparison example CO12, the CoA value gradually increases as the angle increases, but in the third embodiment EX13, the CoA value is significantly reduced by about 1/4 compared to the comparison example CO12. In other words, it is identified that the deviation of the color coordinates is significantly reduced by using the coating layer 130 having a multilayer structure, and thus, a semiconductor light-emitting device having relatively uniform color quality may be obtained.

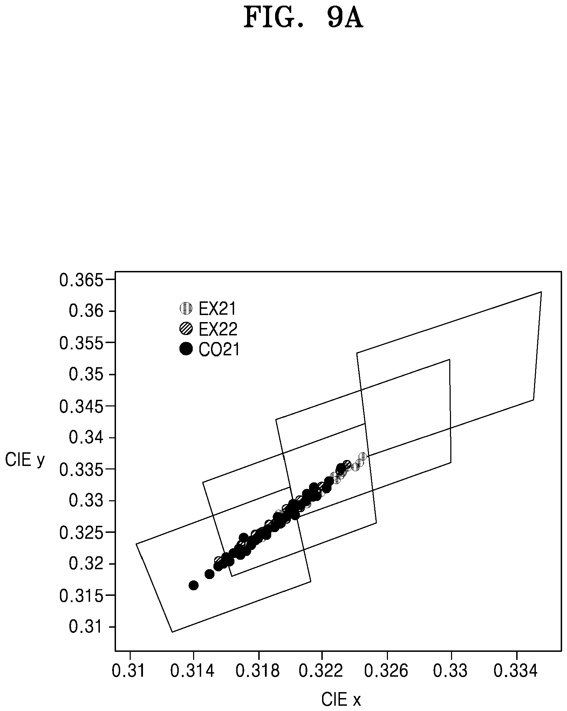

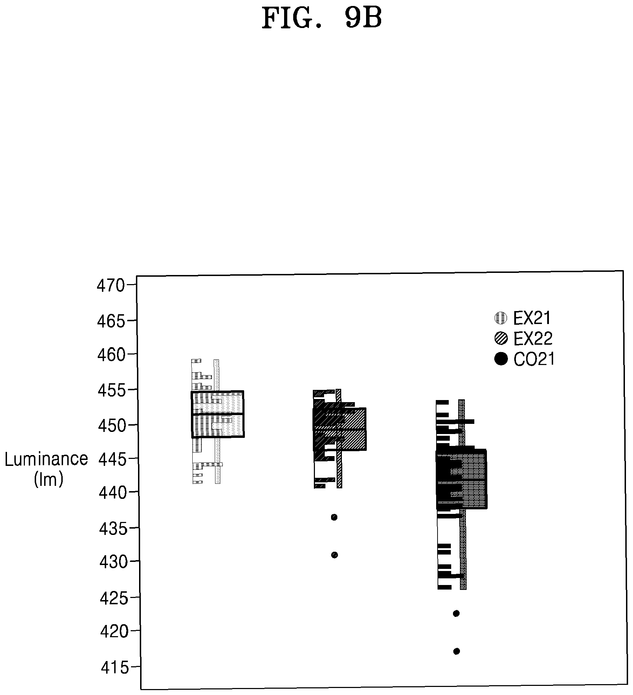

FIG. 9A is a graph of color coordinates characteristics of a semiconductor light-emitting device, according to an example embodiment, and FIG. 9B is a graph of light-flux characteristics of a semiconductor light-emitting device, according to an example embodiment.

Referring to FIGS. 9A and 9B, a first embodiment EX21 may represent a device in which an inclined surface is formed on the sidewall of the wavelength conversion member 120 and the inorganic oxide particles 126 have a first average particle size and a second embodiment EX22 may represent a device in which an inclined surface is formed on the sidewall of the wavelength conversion member 120 and the inorganic oxide particles 126 have a second average particle size, wherein the second average particle size is greater than the first average particle size. A comparison example CO21 may represent a device in which an inclined surface is not formed on the sidewall of the wavelength conversion member 120 and the inorganic oxide particles 126 have a third average particle size, wherein the third average particle size is similar than the second average particle size.

As illustrated in FIG. 9A, it is verified that in all of the first embodiment EX21, the second embodiment EX22, and the comparison example CO21, both x and y, as Commission Internationale de l'Eclairage (CIE) color coordinate values (x, y), implement white color light of good quality in a range of about 0.32 to about 0.33.

As illustrated in FIG. 9B, the first embodiment EX21 and the second embodiment EX22 may show light-flux median values of about 449.1 lumens (lm) and about 450.8 lm, respectively, while the comparison example CO21 shows a light-flux median value of about 445.7 lm. In addition, the comparison example CO21 may show relatively wide distribution of light-flux (for example, the difference between the maximum and minimum values of the light-flux is relatively large, or the standard deviation is relatively large), while the first embodiment EX21 and the second embodiment EX22 may show relatively narrower or uniform distribution of light-flux than the comparison example CO21.

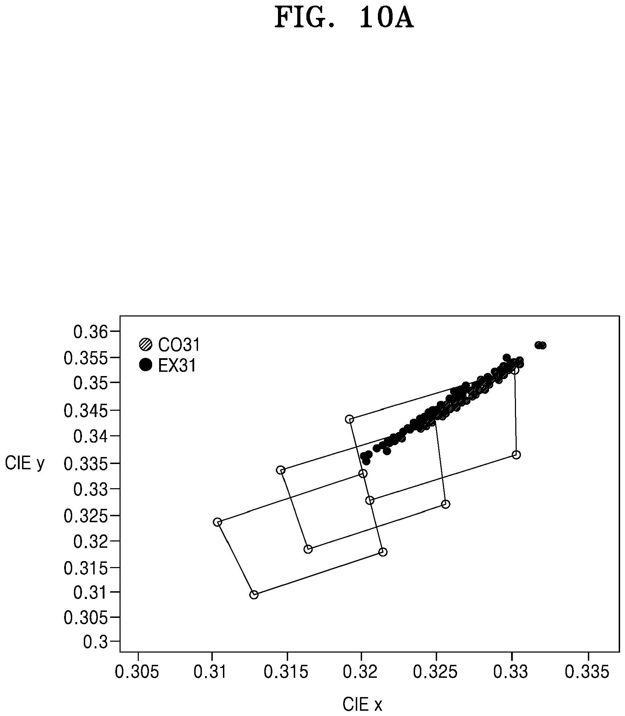

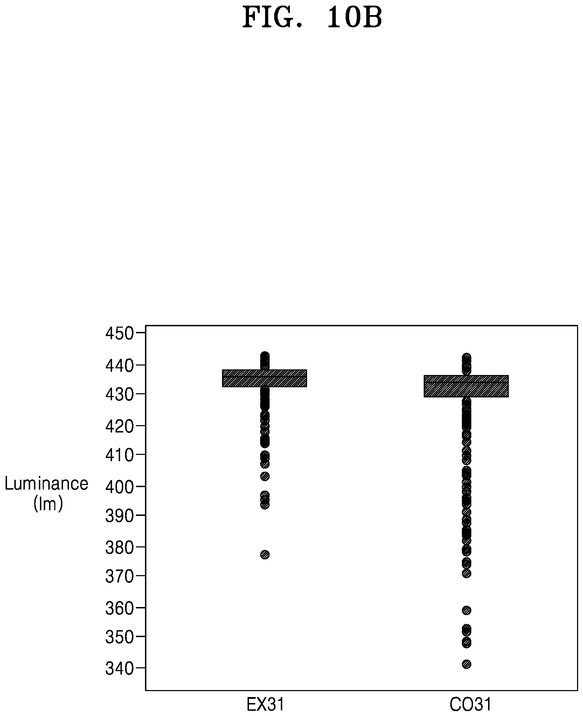

FIG. 10A is a graph of color coordinates characteristics of a semiconductor light-emitting device, according to an example embodiment, and FIG. 10B is a graph of light-flux characteristics of a semiconductor light-emitting device, according to an example embodiment.

Referring to FIGS. 10A and 10B, a first embodiment EX31 may represent a device in which the coating layer 130 includes a total of five material layers: two first material layers 132 including aluminum oxide; and three second material layers 134 including silicon oxide, silicon oxide is arranged on the outermost surface of the coating layer 130, and an inclined surface is formed on a sidewall of the wavelength conversion member 120. A comparison example CO31 may represent a device including a single coating layer 130 including silicon oxide.

As illustrated in FIG. 10A, it is verified that in all of the first embodiment EX31 and the comparison example CO31, both x and y, as CIE color coordinate values (x, y), implement white color light of good quality in a range of about 0.32 to about 0.335.

As illustrated in FIG. 10B, the first embodiment EX31 and the comparison example CO31 may show light-flux median values of about 435.9 lm and about 433.5 lm, respectively, and accordingly, it is verified that the first embodiment EX31 shows an equivalent level of light-flux as the comparison example CO31.

In summary, a semiconductor light-emitting device according to embodiments may significantly reduce angle deviation characteristics by including the DBR structure of a first material layer and a second material layer alternately arranged as a coating layer. On the other hand, although light transmittance in some wavelength ranges is slightly reduced by using the DBR structure, light-flux may be improved by an inclined surface formed on a sidewall of a wavelength conversion member.

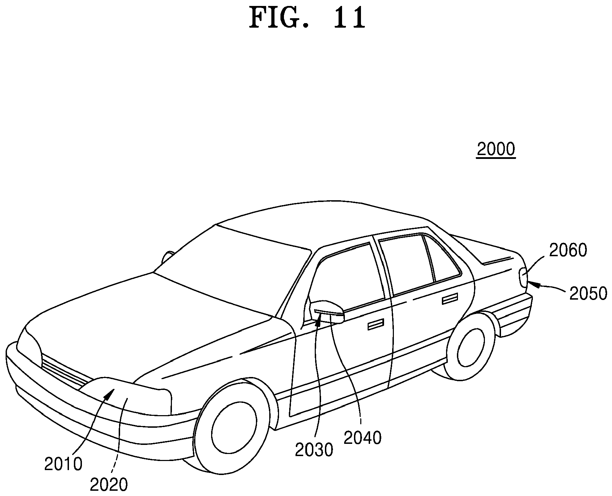

FIG. 11 is a perspective view schematically illustrating a lighting apparatus 2000 including a semiconductor light-emitting device, according to an example embodiment.

Referring to FIG. 11, a head lamp module 2020 may be installed in a head lamp unit 2010 of a vehicle, a side mirror lamp module 2040 may be installed in an outer side mirror unit 2030, and a tail lamp module 2060 may be installed in a tail lamp unit 2050. At least one of the head lamp module 2020, the side mirror lamp module 2040, and the tail lamp module 2060 may include a light source module including at least one of the semiconductor light-emitting devices 100, 100A, and 100B described above.

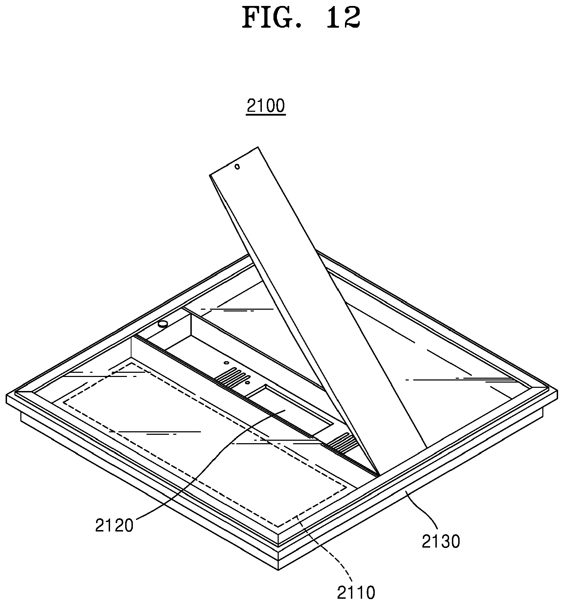

FIG. 12 is a perspective view schematically illustrating a flat panel lighting apparatus 2100 including a semiconductor light-emitting device, according to an example embodiment.

Referring to FIG. 12, the flat panel lighting apparatus 2100 may include a light source module 2110, a power supplier 2120, and a housing 2130.

The light source module 2110 may include a light-emitting device array as a light source, and may include at least one of the semiconductor light-emitting devices described above as a light source. The light source module 2110 may be formed to realize planar phenomenon as a whole.

The power supplier 2120 may be configured to supply power to the light source module 2110. The housing 2130 may have a receiving space such that the light source module 2110 and the power supplier 2120 are received therein and may be formed in a hexahedron shape opened on one side, but the embodiment is not limited thereto. The light source module 2110 may be arranged to emit light to one opened side of the housing 2130.

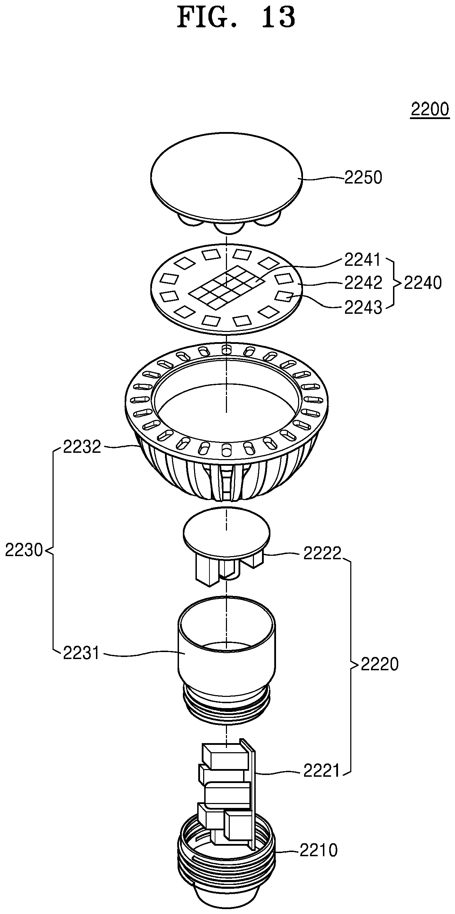

FIG. 13 is an exploded perspective view schematically illustrating a lighting apparatus 2200 including a semiconductor light-emitting device, according to an example embodiment.

Referring to FIG. 13, the lighting apparatus 2200 may include a socket 2210, a power supply unit 2220, a heat dissipation unit 2230, a light source module 2240, and an optical unit 2250.

The socket 2210 may be configured to be replaceable with a socket of a conventional lighting apparatus. Power supplied to the lighting apparatus 2200 may be applied thereto via the socket 2210. The power supply unit 2220 may be divided into a first power supply unit 2221 and a second power supply unit 2222 and may be assembled. The heat dissipation unit 2230 may include an internal heat dissipation unit 2231 and an external heat dissipation unit 2232, the internal heat dissipation unit 2231 may be directly connected to the light source module 2240 and/or the power supply unit 2220, and in this manner, heat may be transmitted to the external heat dissipation unit 2232. The optical unit 2250 may include an internal optical unit (not illustrated) and an external optical unit (not illustrated) and may be configured to evenly disperse light emitted by the light source module 2240.

The light source module 2240 may receive power from the power supply unit 2220 and emit light to the optical unit 2250. The light source module 2240 may include one or more light-emitting device packages 2241, a circuit board 2242, and a controller 2243, and the controller 2243 may store driving information about the light-emitting device package 2241. The light-emitting device package 2241 may include at least one of the semiconductor light-emitting devices 100, 100A, and 100B.

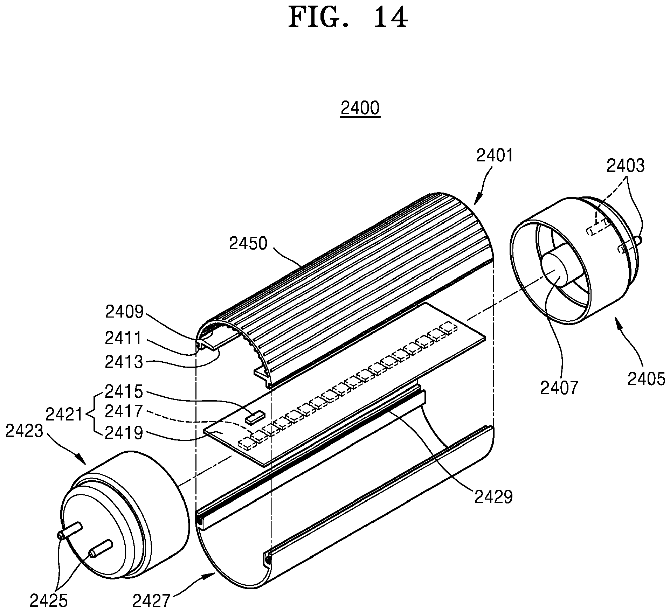

FIG. 14 is a perspective view schematically illustrating a lighting apparatus 2400 of a bar type including a semiconductor light-emitting device, according to an example embodiment.

The lighting apparatus 2400 may include a heat dissipation member 2401, a cover 2427, a light source module 2421, a first socket 2405, and a second socket 2423. A plurality of heat dissipation fins 2450 and 2409 may be formed in an irregular shape on an internal or external surface of the heat dissipation member 2401, and the plurality of heat dissipation fins 2450 and 2409 may be designed to have various shapes and intervals. A support member 2413 may be formed on an inner side of the heat dissipation member 2401. The light source module 2421 may be fixed to the support member 2413. A latching protrusion 2411 may be formed at both ends of the heat dissipation member 2401.

A latching groove 2429 may be formed on the cover 2427, and the latching protrusion 2411 of the heat dissipation member 2401 may be coupled to the latching groove 2429 in a hook coupling structure. The positions, where the latching groove 2429 and the latching protrusion 2411 are respectively formed, may also be mutually exchanged.

The light source module 2421 may include a printed circuit board 2419, a light source 2417, and a controller 2415. The controller 2415 may store driving information about the light source 2417. Circuit wirings for operating the light source 2417 may be formed on the printed circuit board 2419. In addition, components for operating the light source 2417 may also be included. The light source 2417 may include at least one of the semiconductor light-emitting devices 100, 100A, and 100B described above.

The first and second sockets 2405 and 2423, as a pair of sockets, may have a structure in which the first and second sockets 2405 and 2423 are combined to both ends of a cylindrical cover unit including the heat dissipation member 2401 and the cover 2427. For example, the first socket 2405 may include an electrode terminal 2403 and a power supply unit 2407, and a dummy terminal 2425 may be arranged on the second socket 2423. In addition, an optical sensor and/or a communication module may be embedded in any one of the first socket 2405 and the second socket 2423.

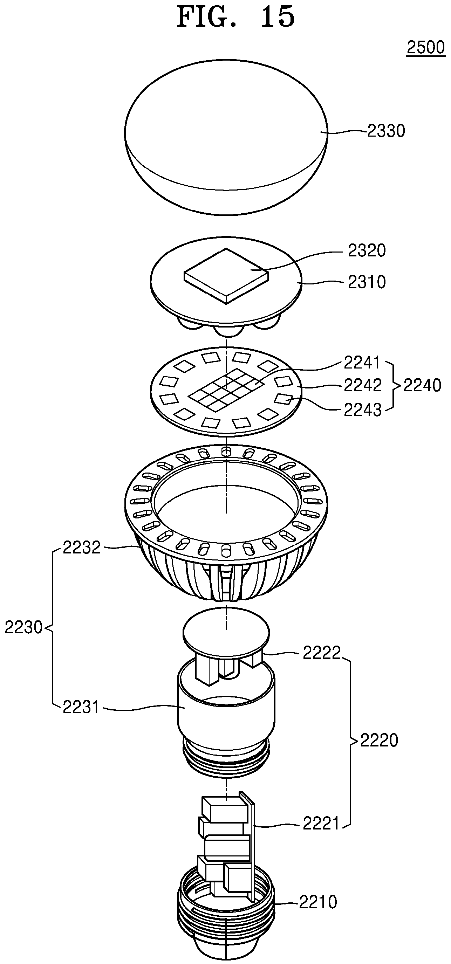

FIG. 15 is an exploded perspective view schematically illustrating a lighting device 2500 including a semiconductor light-emitting device, according to an example embodiment.

The difference between the lighting apparatus 2500 according to the present embodiment and the lighting apparatus 2200 of FIG. 13 may be that, in the lighting apparatus 2500, a reflector 2310 and a communication module 2320 are included on the upper portion of the light source module 2240. The reflector 2310 may evenly spread light from a light source to side and back sides of the reflector 2310 to reduce glare.

The communication module 2320 may be mounted on the upper portion of the reflector 2310, and home-network communication may be implemented by using the communication module 2320. For example, the communication module 2320 may include a wireless communication module using Zigbee, WiFi, or LiFi and may control lighting of lighting apparatuses installed inside and outside a home, such as on/off control and brightness control, by using a smartphone or a wireless controller, or may control electronic appliances inside and outside a home, such as a TV, a refrigerator, an air conditioner, a door lock, an automobile, and an automobile system. The reflector 2310 and the communication module 2320 may be covered by a cover unit 2330.

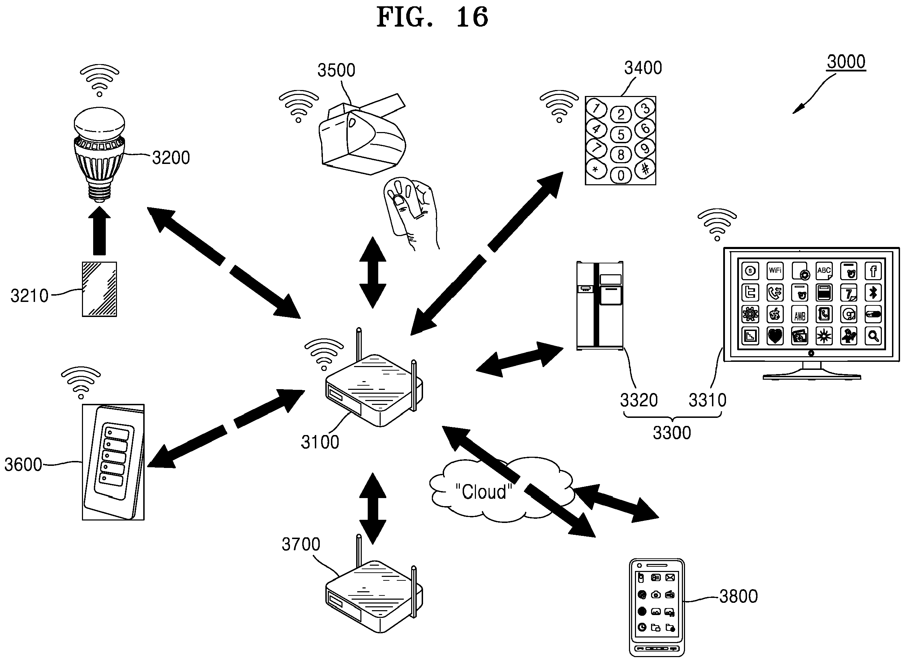

FIG. 16 is a schematic diagram illustrating an indoor lighting control network system 3000 including a semiconductor light-emitting device, according to an example embodiment.

The indoor lighting control network system 3000 may include a complex smart lighting-network system in which lighting technology using light-emitting devices such as a light-emitting diode (LED), Internet of Things (IoT) technology, and wireless communication technology are combined. The indoor lighting control network system 3000 may be implemented by using various lighting devices and wired/wireless communication devices, or may be implemented based on an IoT environment to collect/process various pieces of information and provide the collected/processed various pieces of information to a user.

An LED lamp 3200 included in the indoor lighting control network system 3000 may not only control lighting of the LED lamp 3200 itself by receiving information about the ambient environment from a gateway 3100 but identify and control operation statuses of various devices (3300 to 3800) included in the IoT environment based on a function such as visible light communication of the LED lamp 3200. The LED lamp 3200 may include at least one of the semiconductor light-emitting devices described above. The LED lamp 3200 may be connected to and communicate with the gateway 3100 via a wireless communication protocol, such as WiFi, Zigbee, and LiFi, and to this end, may include at least one lamp communication module 3210.

When the indoor lighting control network system 3000 is applied to the home, various devices (3300 to 3800) may include a home appliance 3300, a digital door lock 3400, a garage door lock 3500, a lighting switch 3600 installed on a wall or the like, a router 3700 for wireless communication network broadcasting, and a mobile device 3800, such as a smartphone, a tablet, and a laptop computer.

In the indoor lighting control network system 3000, the LED lamp 3200 may identify operation statuses of the various devices (3300 to 3800), by using a wireless communication network, such as Zigbee, WiFi, and LiFi, installed in a home, or may automatically control illuminance of the LED lamp 3200 according to the ambient environment/situation. In addition, it may also be possible to control various devices (3300 to 3800) included in the indoor lighting control network system 3000 by using LiFi communication using visible light emitted by the LED lamp 3200.

First of all, the LED lamp 3200 may automatically control the illuminance thereof based on the ambient environment transmitted by the gateway 3100 via the lamp communication module 3210, or the ambient environment information collected by the sensor mounted on the LED lamp 3200. For example, the lighting brightness of the LED lamp 3200 may be automatically controlled according to the type of programs broadcast on a television 3310 or the brightness of the screen of the television 3310. To this end, the LED lamp 3200 may receive operation information about the television 3310 from the lamp communication module 3210 connected to the gateway 3100. The lamp communication module 3210 may be modularized in an integrated form with a sensor and/or controller included in the lamp communication module 3210.

For example, when a certain time elapses after the digital door lock 3400 is locked with no one at home, all turned-on LED lamps 3200 may be turned off to prevent electricity waste. Alternatively, when the security mode is set by using the mobile device 3800 or the like, and the digital door lock 3400 is locked with no one at home, the LED lamp 3200 may also be maintained in a turned-on state.

The operation of the LED lamp 3200 may be controlled according to the ambient environment information collected by using various sensors connected to the indoor lighting control network system 3000. For example, when the indoor lighting control network system 3000 is implemented in a building, it may be possible to turn on or turn off the lighting by combining the lighting, location sensors, and communication modules inside the building, and collecting location information about people inside the building, or to maintain facilities or efficiently utilize the unused space by providing the collected information in real time.

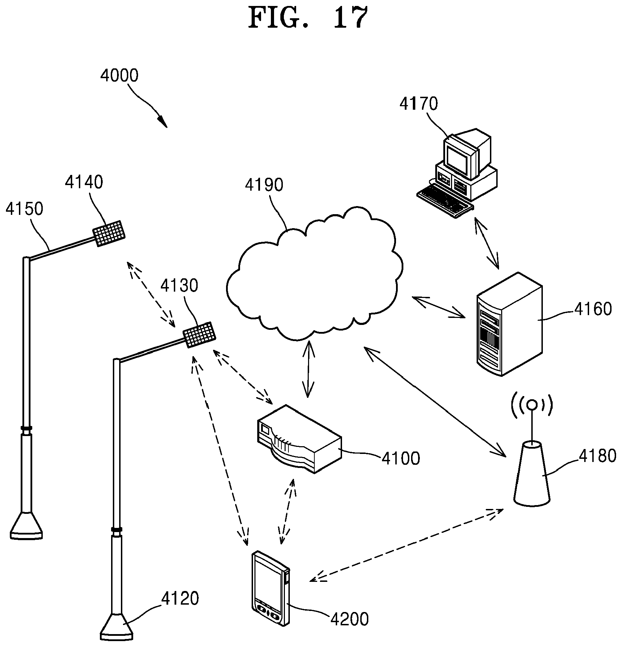

FIG. 17 is a schematic diagram illustrating a network system 4000 including a semiconductor light-emitting device, according to an example embodiment.

The schematic diagram illustrates an embodiment of the network system 4000 applied to an open space. The network system 4000 may include a communication connection device 4100, a plurality of lighting devices 4120 and 4150, which are installed at certain intervals and communicably connected to the communication connection device 4100, a server 4160, a computer 4170 for controlling the server 4160, a communication base station 4180, a communication network 4190 for connecting the communicable devices, a mobile device 4200, etc.

The plurality of lighting devices 4120 and 4150 installed in an open external space, such as a street and a park, may include smart engines 4130 and 4140, respectively. The smart engines 4130 and 4140 may include, in addition to a light-emitting device for emitting light and a driver for driving the light-emitting device, a sensor for collecting information about the ambient environment, a communication module, etc. The light-emitting device included in the smart engines 4130 and 4140 may include at least one of the semiconductor light-emitting devices 100, 100A, and 100B described above.

By using the communication module described above, the smart engines 4130 and 4140 may communicate with other ambient devices according to communication protocols, such as WiFi, Zigbee, and LiFi. The smart engine 4130 may be connected to the smart engine 4140 for communication, and WiFi extension technology (or WiFi mesh technology) may be applied to the communication between the smart engines 4130 and 4140. At least one of the smart engines 4130 and 4140, for example, the smart engine 4130, may be connected to the communication connection device 4100 connected to the communication network 4190 via wired/wireless communication.

The communication connection device 4100 may, as an access point (AP) capable of wired/wireless communication, mediate communication between the communication network 4190 and other devices. The communication connection device 4100 may be connected to the communication network 4190 via at least one of wire/wireless methods and may be mechanically stored, for example, in any one of the plurality of lighting devices 4120 and 4150.

The communication connection device 4100 may be connected to the mobile device 4200 by using a communication protocol such as WiFi. A user of the mobile device 4200 may receive ambient environment information collected by the plurality of smart engines 4130 and 4140, for example, ambient traffic information, weather information, or the like, by using the communication connection device 4100 connected to the smart engine 4130 of the lighting device 4120 near the user. The mobile device 4200 may be connected to the communication network 4190 by using a wireless cellular communication method, such as 3G and 4G, via the communication base station 4180.

On the other hand, the server 4160 connected to the communication network 4190 may receive information collected by the smart engines 4130 and 4140 respectively mounted on the plurality of lighting devices 4120 and 4150, and at the same time, may monitor the operation status of each of the plurality of lighting devices 4120 and 4150, etc. The server 4160 may be connected to the computer 4170 providing a management system, and the computer 4170 may execute software or the like capable of monitoring and managing the operation status of each of the smart engines 4130 and 4140.

While the inventive concept has been particularly shown and described with reference to embodiments thereof, it will be understood that various changes in form and details may be made therein without departing from the scope of the following claims.

## Claims

1. A semiconductor light-emitting device comprising:
a light emitting structure;
a wavelength conversion member arranged on an upper surface of the light emitting structure, the wavelength conversion member including a first surface in contact with the light emitting structure, a second surface opposite to the first surface, and a sidewall, and a first portion of the sidewall adjacent to the first surface is slanted with respect to the first surface; and
a coating layer arranged on the second surface of the wavelength conversion member, the coating layer including a first material layer and a second material layer alternately stacked on the second surface, wherein the first material layer comprises an oxide, and the second material layer comprises magnesium fluoride, MgF₂,
wherein the second material layer is arranged at an uppermost surface of the coating layer.

2. The semiconductor light-emitting device of claim 1,
wherein the wavelength conversion member comprises:
a base material layer;
phosphors dispersed in the base material layer; and
inorganic oxide particles dispersed in the base material layer.

3. The semiconductor light-emitting device of claim 2, wherein the inorganic oxide particles comprise oxide powder having an average particle size of about 1 micrometer to about 50 micrometers.

4. The semiconductor light-emitting device of claim 2 or 3,
wherein the base material layer comprises ceramic or glass, and
wherein the phosphors are configured to convert light emitted by the light emitting structure and having a first wavelength into light having a second wavelength, wherein the second wavelength is greater than the first wavelength.

5. The semiconductor light-emitting device of claim 4, wherein the first wavelength is about 400 nm to about 700 nm.

6. The semiconductor light-emitting device of any one of claims 2 to 5, wherein:
the light emitting structure includes a first conductivity type semiconductor layer, an active layer, and a second conductivity type semiconductor layer, wherein the light emitting structure is configured to emit light having a wavelength range of about 400 nm to about 700 nm,
a second portion of the sidewall adjacent to the second surface extends vertically with respect to the second surface,
the first material layer and the second material layer function as a distributed Bragg reflector, DBR, and
the semiconductor light-emitting device comprises a reflection layer surrounding a sidewall of the light emitting structure and the sidewall of the wavelength conversion member.

7. The semiconductor light-emitting device of any one of claims 1 to 5, further comprising:
a reflection layer surrounding a sidewall of the light emitting structure and the sidewall of the wavelength conversion member,
wherein the reflection layer contacts the first portion of the sidewall of the wavelength conversion member.

8. The semiconductor light-emitting device of any one of claims 1 to 7,
wherein an area of the second surface of the wavelength conversion member is greater than an area of the first surface of the wavelength conversion member, and
wherein the first portion of the sidewall has an inclination angle of about 100 degrees to about 150 degrees with respect to the first surface of the wavelength conversion member.

9. The semiconductor light-emitting device of any one of claims 1 to 8,
wherein the coating layer comprises n first material layers and n second material layers, and
wherein n is a natural number equal to or greater than 1,
wherein the total number of first material layers and second material layers is an even number, and
wherein the first material layers are arranged on the second surface of the wavelength conversion member.

10. The semiconductor light-emitting device of any one of claims 1 to 8,
wherein the coating layer comprises n first material layers and (n+1) second material layers, and
wherein n is a natural number equal to or greater than 1,
wherein the total number of first material layers and second material layers is an odd number, and
wherein the second material layers are arranged on the second surface of the wavelength conversion member.

11. The semiconductor light-emitting device of any one of claims 1 to 10,
wherein the first material layer has a first refractive index,
wherein the second material layer has a second refractive index, and
wherein the second refractive index is less than the first refractive index.

12. The semiconductor light-emitting device of any one of claims 1 to 11, wherein the second material layer arranged at the uppermost surface of the coating layer is formed as a continuous material layer extending in a first direction in parallel with the second surface of the wavelength conversion member.

13. The semiconductor light-emitting device of claim 12, wherein an upper surface of the second material layer arranged at the uppermost surface of the coating layer has a flat profile.

14. The semiconductor light-emitting device of any one of claims 1 to 13, wherein the first material layer comprises at least one of aluminum oxide, titanium oxide, hafnium oxide, tantalum oxide, silicon oxide, zirconium oxide, tungsten oxide, magnesium oxide, silicon nitride, cerium oxide, and tin oxide.

15. The semiconductor light-emitting device of any one of claims 1 to 14, wherein the first surface entirely covers the upper surface of the light emitting structure.
